# FASCICULE DE BREVET EUROPEEN

(11) **EP 3 975 231 B1**
(45) Date de publication et mention de la délivrance du brevet: **27.09.2023**
(21) Numéro de dépôt: 21192958.3
(22) Date de dépôt: 25.08.2021
(51) Int. Cl.: H01L 21/677

(54) **DISPOSITIF DE RETOURNEMENT DE PLAQUETTES**
WAFERDREHVORRICHTUNG
WAFER TURNING DEVICE

(30) Priorité: 28.09.2020 FR 2009838
(43) Date de publication de la demande: 30.03.2022
(73) Titulaire: Commissariat à l'Energie Atomique et aux Energies Alternatives, 75015 Paris (FR)
(72) Inventeur: JERONIMO, Pedro, 38054 GRENOBLE CEDEX 09 (FR)
(74) Mandataire: Cabinet Nony

(56) Documents cités:
- DE-A1-102010 060 517
- US-A1- 2012 037 475

## Description

### Domaine technique

La présente invention concerne le retournement des plaquettes, notamment durant le processus de fabrication de cellules photovoltaïques.

Classiquement, une cellule photovoltaïque comporte une plaquette, communément dénommée « *wafer »* en anglais, qui présente une forme de pavé droit de faible épaisseur. La plaquette est composée d'un matériau semi-conducteur, généralement du silicium. La fabrication d'une telle cellule photovoltaïque peut nécessiter le retournement de la plaquette au cours du processus de fabrication.

### Technique antérieure

Dans les systèmes de retournement connus, il y a un contact direct avec la plaquette lors de la manipulation de celle-ci.

On connaît par exemple par la demande US 2012/0037475 un système dans lequel la plaquette est, afin d'être retournée, placée entre deux convoyeurs disposés parallèlement l'un à l'autre, et entre lesquels la plaquette est serrée. L'ensemble est alors retourné.

DE 102010060517 décrit également un dispositif de retournement de plaquettes.

La mise en contact de la face de la plaquette avec l'un ou les convoyeurs, lors de l'introduction de la plaquette et pendant le retournement de l'ensemble, peut provoquer l'apparition de rayures ou tâches sur les couches, par exemple antireflet, passivantes, dopantes ou barrières de diffusion, préalablement déposées sur la plaquette.

La présence de rayures ou autres défauts ne peut pas être acceptée. En effet, une rayure a plusieurs effets négatifs sur les propriétés électriques d'une cellule photovoltaïque comportant la plaquette. Elle peut détériorer une surface texturée et ainsi réduire l'absorption lumineuse de la cellule photovoltaïque. Elle peut générer une ouverture locale d'une couche antireflet, réduisant ainsi l'absorption lumineuse de la cellule photovoltaïque et donc son courant J_{cc}, ou d'une couche passivante, dégradant la V_{oc} finale de la cellule photovoltaïque, ou d'une couche dopante ou barrière de diffusion, dégradant l'uniformité de dopage et/ou la perméabilité de la barrière de diffusion aux diffusions et générant des pertes résistives et/ou de shunt dans la cellule photovoltaïque, impactant son facteur de forme.

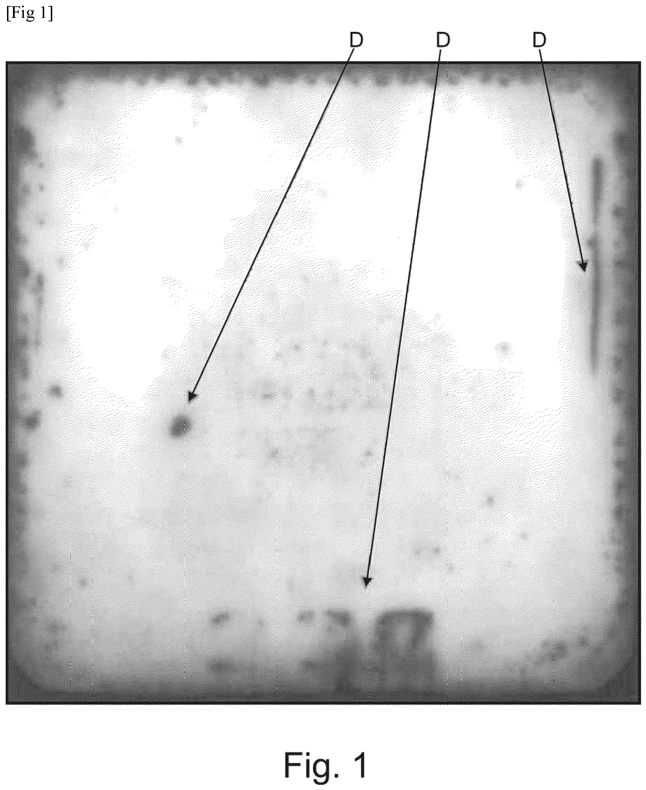

A titre illustratif, on a représenté sur la figure 1 une plaquette obtenue en utilisant un dispositif de l'art antérieur. Cette plaquette présente des rayures, tâches ou autres défauts, qui sont indiqués par des flèches référencées D.

Par ailleurs, outre le fait que les rayures dégradent les propriétés électriques de la plaquette, leur nombre, leurs positions et leur distribution en surface de la plaquette varie d'une plaquette à l'autre au sein d'une pluralité de plaquettes initialement identiques.

Il en résulte une variabilité importante des propriétés électriques des plaquettes après retournement, certains étant exempts de rayures, alors que d'autres en comportent plusieurs.

En outre, ces défauts engendrent une perte de rendement.

Il existe donc un besoin pour limiter l'apparition de défauts lors de la manipulation des plaquettes, et en particulier le développement de rayures en surface des plaquettes lors de leur retournement, ainsi que pour réduire la variabilité des propriétés électriques des plaquettes à la suite de leur retournement.

La présente invention vise à répondre à ce besoin.

### Résumé de l'invention

L'invention a ainsi pour objet, selon l'un de ses aspects, un dispositif de retournement de plaquettes tel que défini dans la revendication 1.

Par « plaquette », autrement dénommée « wafer » en anglais, on désigne un substrat ayant une forme de pavé droit de faible épaisseur, formé à partir d'un matériau semi-conducteur, généralement du silicium.

Lors de l'introduction de la plaquette dans le dispositif selon l'invention, les jets de gaz maintiennent avantageusement la plaquette à distance des roues. Elles permettent d'éviter alors la mise en contact entre au moins une partie de la plaquette et la roue. L'apparition de défauts sur la plaquette est de cette façon limitée.

Une fois dans le dispositif selon l'invention, la plaquette n'entre pas en contact avec les roues, et en particulier elle n'entre pas en contact avec des faces des fentes ni la tranche de chaque roue. La plaquette est maintenue entre différents jets de gaz provenant des différentes buses des deux fentes correspondantes pendant son retournement.

### Exposé de l'invention

Les fentes d'une roue s'étendent radialement. Les fentes s'étendent sur toute l'épaisseur de la roue correspondante. Elles sont traversantes dans l'épaisseur de la roue. Les fentes d'une roue débouchent radialement vers l'extérieur sur la tranche de la roue.

Le dispositif comporte des buses sur les faces des fentes, face à la plaquette. Chaque roue peut comporter des buses sur chaque face de chaque fente.

La pluralité de buses peut comporter, pour une fente donnée, au moins une première buse disposée à proximité de l'entrée de la fente, vers le bord de la roue. Pour une fente donnée, le dispositif peut comporter au moins une première buse sur une face de la fente et au moins une première buse sur une face opposée de la fente. Pour une fente donnée, le dispositif peut ainsi comporter deux trios de premières buses, avec un trio de premières buses sur chacune des faces opposées d'une fente.

La pluralité de buses peut également comporter, pour une fente donnée, au moins une deuxième buse à proximité du fond de la fente, plus près de l'arbre du dispositif que la ou les premières buses. Pour une fente donnée, le dispositif peut comporter au moins une deuxième buse sur une face de la fente et au moins une deuxième buse sur une face opposée de la fente. Pour une fente donnée, le dispositif peut ainsi comporter deux fois cinq deuxièmes buses, avec un groupe de cinq deuxièmes buses sur chacune des faces opposées d'une fente.

La pluralité de buses peut enfin comporter, pour une fente donnée, au moins une buse de fond disposée dans le fond de la fente, à proximité de l'arbre du dispositif, lequel porte les roues. La ou les buses de fond peuvent être disposées sur l'arbre du dispositif. Pour une fente donnée, le dispositif peut ainsi comporter une paire de buses de fond disposées côte à côte dans le fond de la fente.

Pour une fente donnée, le dispositif peut comporter entre 4 et 25 buses, mieux entre 6 et 22 buses, voire entre 8 et 20, par exemple 18 buses. Les différentes buses permettent le maintien de la plaquette à la fois longitudinalement et verticalement, lorsque le dispositif est en rotation pour retourner la plaquette. Elles permettent également le maintien de la plaquette pour éviter le déplacement de celle-ci en contact avec un convoyeur d'entrée dans le dispositif et de sortie du dispositif.

Le dispositif peut comporter une pluralité de capteurs de position configurés pour déterminer la position de la plaquette par rapport aux roues. Les capteurs peuvent être par exemple des capteurs de distance, notamment de type laser ou capacitif. Les capteurs peuvent être disposés sur les faces de fentes, faces à la plaquette.

Chaque roue peut comporter des capteurs sur chaque face de chaque fente.

La pluralité de capteurs peut comporter, pour une fente donnée, au moins un premier capteur disposé à proximité de l'entrée de la fente, vers le bord de la roue. Pour une fente donnée, le dispositif peut comporter au moins un premier capteur sur une face de la fente et au moins un premier capteur sur une face opposée de la fente. Pour une fente donnée, le dispositif peut ainsi comporter deux paires de premiers capteurs, une paire de premiers capteurs sur chacune des faces opposées d'une fente.

La pluralité de capteurs peut également comporter, pour une fente donnée, au moins un deuxième capteur à proximité du fond de la fente, plus près de l'arbre du dispositif que le ou les premiers capteurs. Pour une fente donnée, le dispositif peut comporter au moins un deuxième capteur sur une face de la fente et au moins un deuxième capteur sur une face opposée de la fente. Pour une fente donnée, le dispositif peut ainsi comporter deux paires de deuxièmes capteurs, une paire de deuxièmes capteurs sur chacune des faces opposées d'une fente.

La pluralité de capteurs peut enfin comporter, pour une fente donnée, au moins un capteur de fond disposé dans le fond de la fente, à proximité de l'arbre du dispositif, lequel porte les roues. Le ou les capteurs de fond peuvent être disposés sur l'arbre du dispositif. Pour une fente donnée, le dispositif peut ainsi comporter une paire de capteurs de fond disposés côte à côte dans le fond de la fente.

Pour une fente donnée, le dispositif peut comporter entre 4 et 15 capteurs, mieux entre 6 et 14 capteurs, voire entre 8 et 12, par exemple 10 capteurs pour une fente.

Le flux de gaz peut être asservi à la position de la plaquette dans la fente de la roue. Les flux de gaz sortant de buses peuvent être régulés en pression et/ou en débit, notamment à la fois en pression et en débit. Plus précisément, chaque buse peut comporter une vanne d'entrée asservie à la position de la plaquette dans la fente de la roue, le flux de gaz pouvant être proportionnelle à la position de la plaquette dans la fente de la roue par rapport aux faces de la fente. Une valeur minimale du flux de gaz peut être nulle. Le flux de gaz peut être choisi en fonction de la masse de la plaquette.

La masse de la plaquette peut être comprise entre 5 et 10 g par exemple, mieux entre 6 et 9 g. L'épaisseur de la plaquette peut être comprise entre 50 et 180 µm, étant par exemple de 140 µm.

Le gaz peut être choisi dans la liste suivante, qui n'est pas limitative : air, O2, N2, H2, ou tout autre gaz comprimé. Le gaz choisi peut être de préférence dépourvu d'humidité, afin de préserver une surface de la plaquette de toute contamination. On peut utiliser de préférence du N2.

Chaque roue peut comporter un nombre égal de fente. Le nombre de fente d'une roue peut être compris entre 2 et 20, mieux entre 3 et 16, voire entre 4 et 14, étant par exemple compris entre 6 et 12. Le nombre de fentes d'une roue peut par exemple être de 8, 10 ou 12.

Les fentes d'une roue peuvent être régulièrement répartie sur la roue, deux fentes consécutives étant par exemple écartées angulairement l'une de l'autre d'un angle α donné qui peut être le même entre toutes les fentes consécutives.

Le dispositif peut recevoir plusieurs plaquettes à la fois, dans les fentes qui sont placées au-dessus d'un plan horizontal. Dans un exemple de réalisation, le dispositif peut recevoir simultanément jusqu'à au moins 4 plaquettes à la fois, mieux au moins 5, voire au moins 6.

Le dispositif peut ainsi recevoir simultanément un nombre de plaquettes compris entre 1 et 10, mieux entre 2 et 8, voire entre 3 et 7, étant par exemple de 4, 5 ou 6.

Les fentes de chacune des deux roues sont de préférence disposées de la même manière, avec le même écartement angulaire. En outre, deux fentes de chacune des roues ont de préférence la même disposition angulaire, de sorte qu'une plaquette peut être insérée simultanément dans les deux fentes des deux roues. Les deux roues peuvent être indexée sur un arbre du dispositif à cet effet.

Une plaquette peut être reçue dans une fente de chaque roue, les deux fentes des deux roues étant sans décalage angulaire. Les deux fentes des deux roues sont angulairement face à face. Ainsi, la plaquette est reçue dans les deux fentes à la fois, ayant ainsi des points d'appui de part et d'autre d'un plan de symétrie de celle-ci, ce qui favorise son maintien en équilibre sans contact avec les roues.

Les deux roues peuvent être symétriques l'une de l'autre par rapport à un plan central du dispositif.

Le dispositif peut comporter un calculateur permettant de contrôler les commandes des buses d'arrivée de gaz. Le dispositif peut ne comporter qu'un seul calculateur commandant les buses des deux roues à la fois. L'unique calculateur peut être disposé d'un seul côté des deux roues. Cela permet d'éviter le passage de signaux de commandes dans un arbre du dispositif.

Chaque buse peut être alimentée en gaz par l'intermédiaire d'une vanne proportionnelle asservie à la position de la plaquette. Les différentes buses sont configurées pour fournir des flux de gaz dans différentes directions, afin de permettre la modification et l'ajustement de la position de la plaquette dans la fente.

Des buses peuvent être regroupées par trois, une buse centrale fournissant un flux de gaz central orienté perpendiculairement à la plaquette, et deux buses latérales fournissant deux flux de gaz respectivement orientés obliquement vers la gauche et vers la droite par rapport à la plaquette, en éloignement du flux central.

Le dispositif peut comporter un moteur d'entrainement des roues en rotation. Le moteur peut être unique. Il peut être disposé sur un côté des roues, sur un arbre du dispositif. L'arbre peut permettre l'entrainement en rotation des deux roues simultanément.

Le dispositif peut comporter deux joints tournants, disposés de part et d'autre des deux roues, qui sont configurés pour permettre l'arrivée du gaz et le contrôle des commandes des buses et des capteurs de chacune des deux roues. En particulier, le joint peut véhiculer le bus de communication pour les vannes proportionnelles de buses et les signaux des capteurs.

Le dispositif peut comporter deux organes de distribution du gaz chacun disposés de part et d'autre des deux roues, chacun alimentant en gaz la roue adjacente. Les deux organes de distribution du gaz peuvent être commandés par l'unique calculateur. Seul un flux de gaz peut passer dans l'arbre du dispositif.

Le dispositif peut être configuré pour que les roues soient mobiles entre une première position de réception de la plaquette, dans laquelle la fente destinée à recevoir la plaquette est placée à l'horizontal devant un convoyeur d'entrée, et une position de sortie de la plaquette, dans laquelle la fente recevant la plaquette est placée à l'horizontal devant un convoyeur de sortie.

Le dispositif peut être configuré pour pouvoir être traversé par une plaquette sans retournement de celle-ci.

Chaque roue peut comporter une fente diamétralement traversante permettant le passage de la plaquette sans que celle-ci ne soit entraînée en rotation par les roues.

En outre, l'arbre du dispositif peut comporter une fente transversale horizontale permettant le passage de la plaquette sans que celle-ci ne soit entraînée en rotation par les roues.

La plaquette peut être entraînée à travers le dispositif par les convoyeurs d'entrée et de sortie sans entrer en contact avec le dispositif. Elle peut être supportée par ceux-ci, sans être maintenue dans le dispositif de retournement par des flux de gaz. La fente diamétralement traversante d'une roue peut être dépourvue de capteurs et de buses. Afin de permettre le passage de la plaquette sans retournement, les roues sont placées de sorte que les fentes diamétralement traversantes des deux roues soient à l'horizontal, dans le prolongement de la fente transversale horizontale de l'arbre du dispositif.

La fente diamétralement traversante d'une roue peut être située angulairement entre deux fentes de réception d'une plaquette, notamment au milieu, par exemple à écart angulaire constant de chacune d'elles.

L'invention a encore pour objet, indépendamment ou en combinaison avec ce qui précède, un ensemble comportant un dispositif tel que défini plus haut, ainsi qu'un convoyeur d'entrée et un convoyeur de sortie.

Le convoyeur d'entrée est configuré pour permettre l'acheminement de la plaquette dans les fentes horizontales des deux roues du dispositif de retournement, et le convoyeur de sortie est configuré pour recevoir la plaquette à sa sortie du dispositif de retournement, lorsque les fentes des roues sont de nouveau disposées à l'horizontale, de l'autre côté du dispositif de retournement.

Les deux convoyeurs d'entrée et de sortie peuvent comporter chacun une ou des courroies de transport de la plaquette, qui sont entrainées en rotation de façon à permettre le déplacement de la plaquette à l'horizontale. La plaquette peut être positionnée dans les fentes du dispositif par le déplacement du convoyeur d'entrée. Après son positionnement, les capteurs de la fente permettent de déterminer la position de la plaquette. Plus précisément, on peut déterminer la distance entre la plaquette et chaque capteur de la fente.

Lorsque les roues commencent à tourner pour retourner la plaquette, les buses libèrent chacune un flux de gaz afin de maintenir la plaquette en position dans la fente. Les flux de gaz des buses sont contrôlés afin de conserver les distances enregistrées entre la plaquette et chaque capteur de la fente. On active les différentes buses en fonction de la position de la plaquette, au fur et à mesure du retournement.

L'ensemble peut être intégré dans une ligne de fabrication de cellules photovoltaïques.

L'invention a encore pour objet, indépendamment ou en combinaison avec ce qui précède, un procédé de fabrication d'une cellule photovoltaïque, comportant les étapes suivantes :
(a) introduire une plaquette dans un dispositif de retournement selon l'une quelconque des revendications précédentes,
(b) entraîner en rotation les deux roues du dispositif, en asservissant les flux de gaz sortant des buses à la position de la plaquette dans une fente correspondante de chacune des roues.

La plaquette peut être introduite dans le dispositif en étant entraînée horizontalement par un convoyeur d'entrée.

La plaquette est placée dans les deux fentes des deux roues du dispositif, lesquelles se font face. La plaquette est alors maintenue entre différents jets de gaz provenant des différentes buses des deux fentes correspondantes.

Le procédé peut également comporter l'étape suivante :
(c) retirer la plaquette du dispositif, une fois que les roues ont effectué une rotation de 180°.

La plaquette a alors effectué un demi-tour sur elle-même.

La plaquette peut être retirée en étant entraînée horizontalement par un convoyeur de sortie.

Au cours de l'étape (a), (b) et (c), il n'y pas de contact entre la plaquette et la ou les roues.

### Brève description des dessins

L'invention pourra être mieux comprise à la lecture de la description détaillée qui va suivre, d'exemples de réalisation non limitatifs de celle-ci, et à l'examen du dessin annexé, sur lequel :
[Fig 1] La figure 1 est une vue de face d'une plaquette obtenue en utilisant un dispositif de retournement de l'art antérieur.
[Fig 2a] La figure 2a est une vue en perspective, schématique et partielle, d'un dispositif de retournement réalisé conformément à l'invention.
[Fig 2b] La figure 2b est une vue en perspective, schématique et partielle, du dispositif de retournement de la figure 1.
[Fig 2c] La figure 2c est une vue en perspective, schématique et partielle, du dispositif de retournement de la figure 1.
[Fig 2d] La figure 2d est une vue en perspective, schématique et partielle, du dispositif de retournement de la figure 1.
[Fig 2e] La figure 2e est une vue en perspective, schématique et partielle, du dispositif de retournement de la figure 1.
[Fig 2f] La figure 2f en est une vue de détail.
[Fig 3a] La figure 3a est une vue en perspective, schématique et partielle, du dispositif de retournement de la figure 1 en cours d'utilisation.
[Fig 3b] La figure 3b est une vue de détail du dispositif de retournement de la figure 1 en cours d'utilisation.
[Fig 3c] La figure 3c est une vue de détail du dispositif de retournement de la figure 1 en cours d'utilisation.
[Fig 3d] La figure 3d est une vue de détail du dispositif de retournement de la figure 1 en cours d'utilisation.
[Fig 3e] La figure 3e est une vue de détail du dispositif de retournement de la figure 1 en cours d'utilisation.
[Fig 4] La figure 4 est une vue et coupe et de détail du dispositif de retournement de la figure 1.
[Fig 5a] La figure 5a est une vue de détail du dispositif de retournement de la figure 1 en cours d'utilisation.
[Fig 5b] La figure 5b est une vue de détail du dispositif de retournement de la figure 1 en cours d'utilisation.
[Fig 5c] La figure 5c est une vue de détail du dispositif de retournement de la figure 1 en cours d'utilisation.
[Fig 6] La figure 6 est un schéma en blocs illustrant le procédé selon l'invention.
[Fig 7] La figure 7 est un schéma en blocs illustrant le calculateur du dispositif selon l'invention.
[Fig 8a] La figure 8a est une vue en perspective, schématique et partielle, du dispositif de la figure 1.
[Fig 8b] La figure 8b est une vue en perspective, schématique et partielle, du dispositif de la figure 1.

### Description détaillée

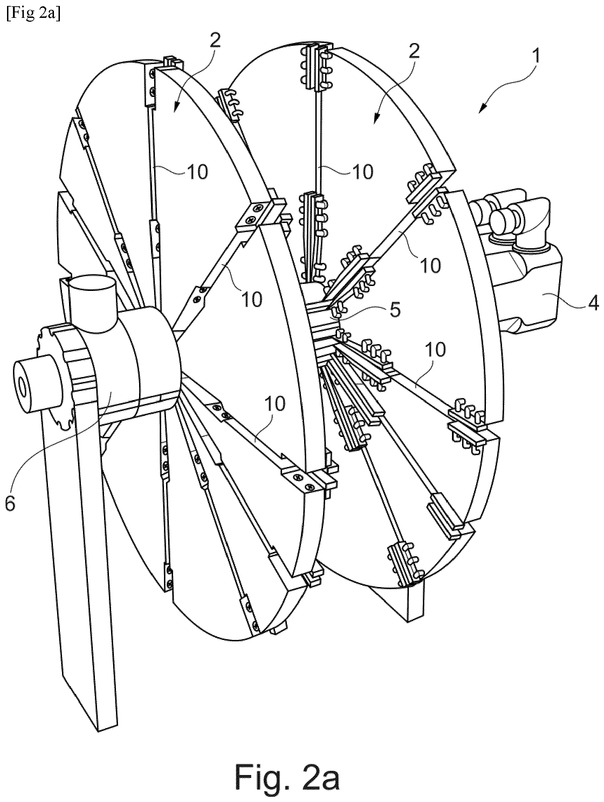

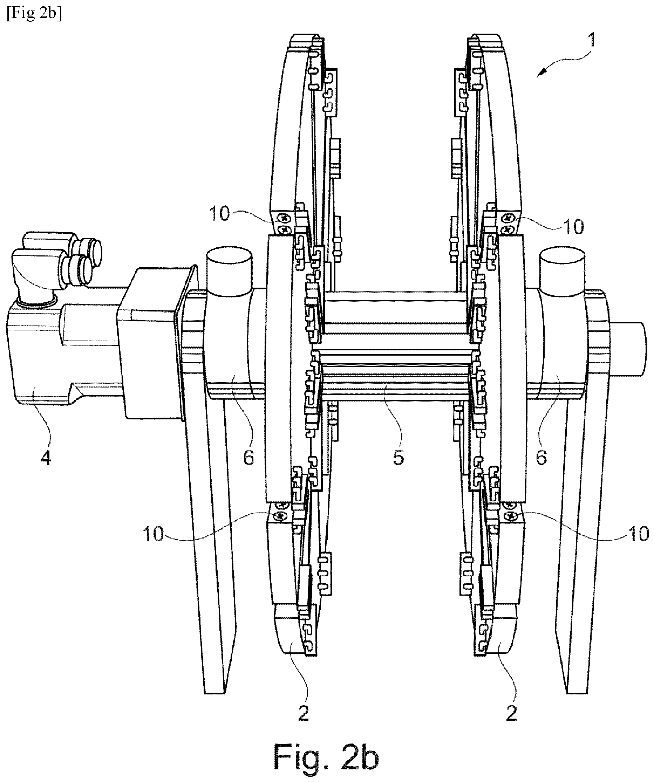

On a illustré aux figures 2a à 5c un dispositif 1 de retournement de plaquettes P. Le dispositif 1 comporte deux roues 2 parallèles l'une à l'autre, étant symétriques l'une de l'autre par rapport à un plan central du dispositif, et un moteur 4 d'entrainement des roues 1 en rotation. Le moteur 4 peut être unique, comme illustré, ou en variante le dispositif peut comporter deux moteurs. Le moteur est disposé sur un côté des roues 2, sur un arbre 5 du dispositif. L'arbre 5 permet l'entrainement en rotation des deux roues 2 simultanément, comme visible sur les figures 2a et 2b.

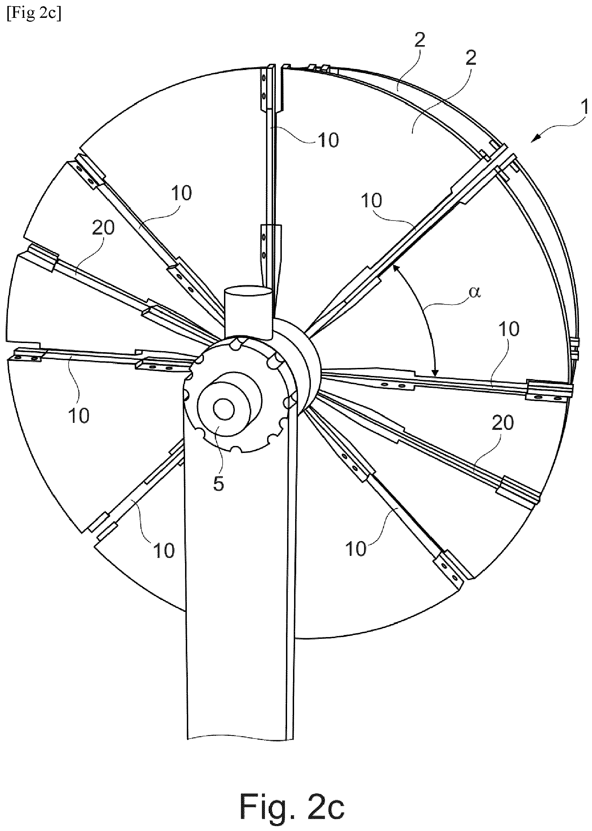

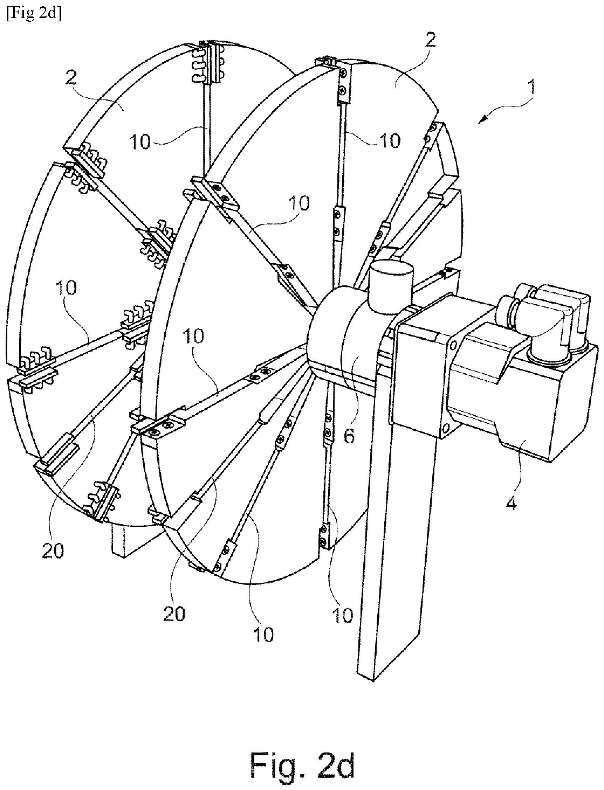

Une roue 2 comporte des fentes 10 destinées à recevoir chacune une plaquette P à retourner, comme illustré sur les figures 2c et 2d. A cet effet, les fentes 10 sont pourvues d'une pluralité de buses 12 d'arrivée de gaz G, des flux de gaz G sortant des buses 12 permettant de maintenir la plaquette P dans une fente 10 correspondante de chacune des roues 2 sans contact avec les roues 2. Le gaz est de préférence du N2.

Chaque roue 2 comporte un nombre égal de fente. Le nombre de fente pour la réception d'une plaquette dans la roue est ici de 8. Les fentes d'une roue sont régulièrement réparties sur la roue, deux fentes consécutives étant écartées angulairement l'une de l'autre d'un angle α donné qui est le même entre toutes les fentes consécutives, comme illustré sur la figure 2c.

Ainsi, le dispositif peut recevoir plusieurs plaquettes à la fois, dans les fentes qui sont placées au-dessus d'un plan horizontal. Dans cet exemple de réalisation, le dispositif peut recevoir simultanément jusqu'à au moins 4 à 5 plaquettes à la fois.

Le dispositif comporter en outre deux joints tournants 6, disposés de part et d'autre des deux roues 2, qui sont configurés pour permettre l'arrivée de gaz G dans les roues 2 et le contrôle des commandes des buses 12 et de capteurs de chacune des deux roues.

Les fentes 10 d'une roue 2 s'étendent radialement, et sur toute l'épaisseur de la roue 2 correspondante. Elles sont traversantes dans l'épaisseur de la roue. Les fentes d'une roue débouchent radialement vers l'extérieur sur la tranche de la roue.

Les buses sont disposées sur les faces 10a, 10b des fentes 10, face à la plaquette P. Chaque roue comporter des buses sur chaque face de chaque fente, comme illustré sur les 2e et 2f.

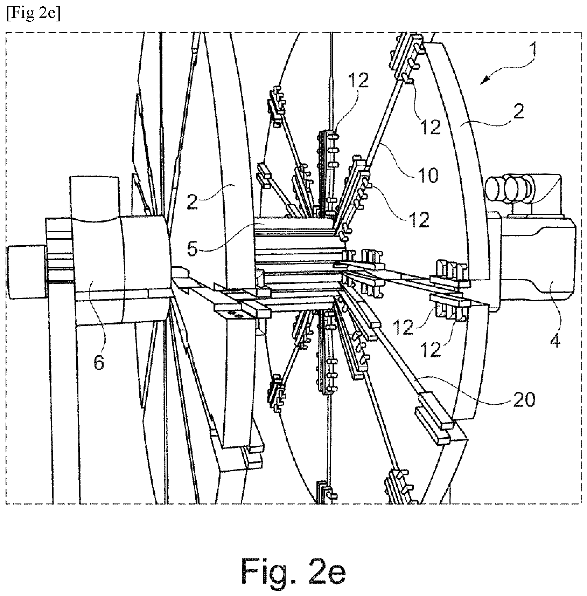

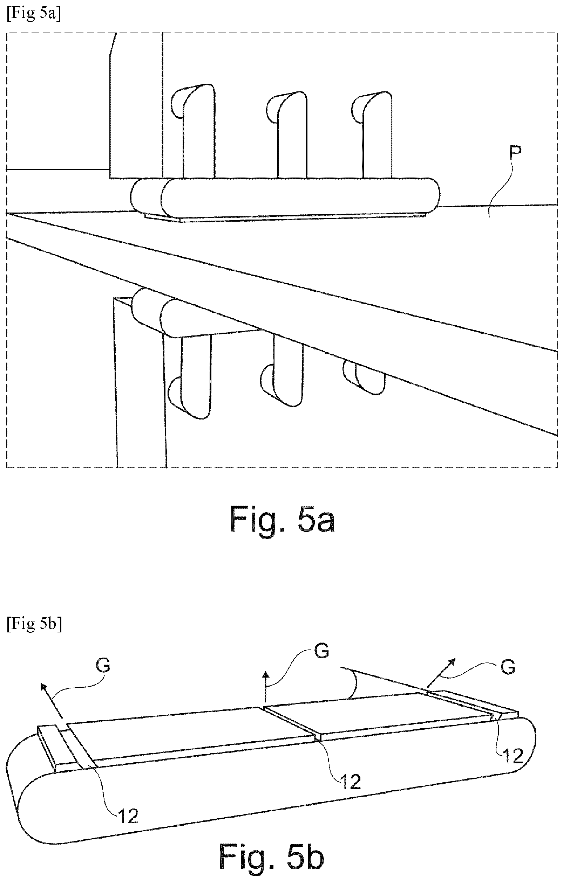

Pour une fente 10 donnée, le dispositif comporte deux trios de premières buses 12, avec un trio de premières buses sur chacune des faces 10a, 10b opposées de la fente 10, comme illustré sur les figures 2e, 3a, 3b et 5a. On voit sur la figure 5a les conduits d'arrivée de gaz G pour chacun des buses 12, et sur la figure 5b les orifices de sortie des buses 12. Les orifices de sortie ont une forme générale allongée, qui s'étend longitudinalement parallèlement à l'axe de rotation des roues et au plan de la plaquette.

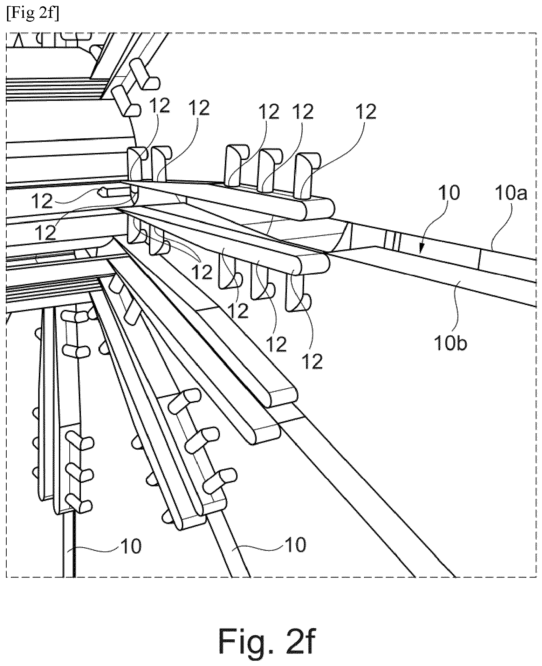

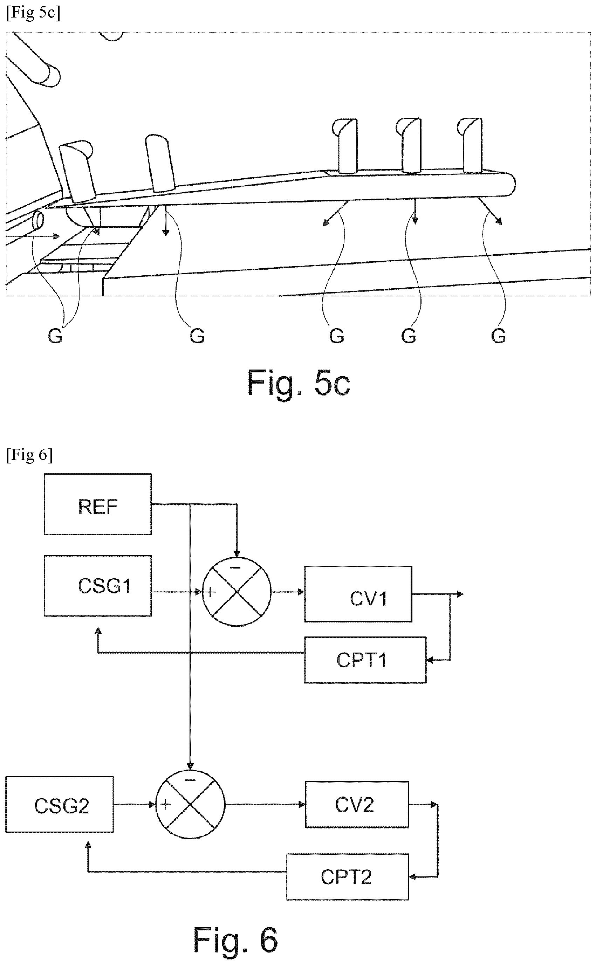

Pour une fente donnée, le dispositif comporter également deux fois cinq deuxièmes buses 12, avec un groupe de cinq deuxièmes buses sur chacune des faces 10a, 10b opposées de la fente 10, comme illustré sur les figures 2f et 5c.

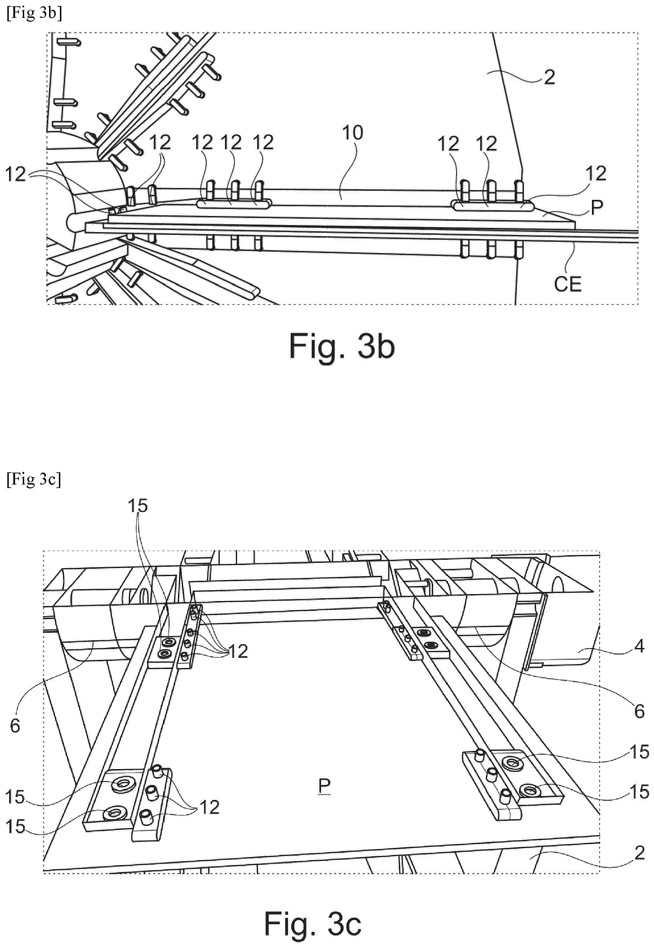

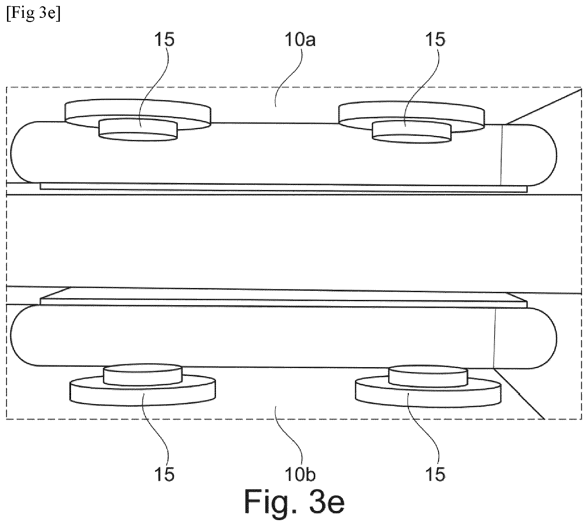

Enfin, le dispositif comporte une paire de buses 12 de fond disposées côte à côte dans le fond de la fente 10, comme illustré sur la figure 3b.

Pour une fente donnée, le dispositif comporte dans l'exemple illustré 18 buses, visible sur la figure 3b.

Les différentes buses permettent le maintien de la plaquette à la fois longitudinalement et verticalement, lorsque le dispositif est en rotation pour retourner la plaquette.

Afin de déterminer la position de la plaquette par rapport aux roues, le dispositif comporte une pluralité de capteurs de position 15 qui sont disposés sur les faces de fentes, faces à la plaquette, comme illustré sur les figures 3c à 3e. Chaque roue comporte des capteurs sur chaque face de chaque fente.

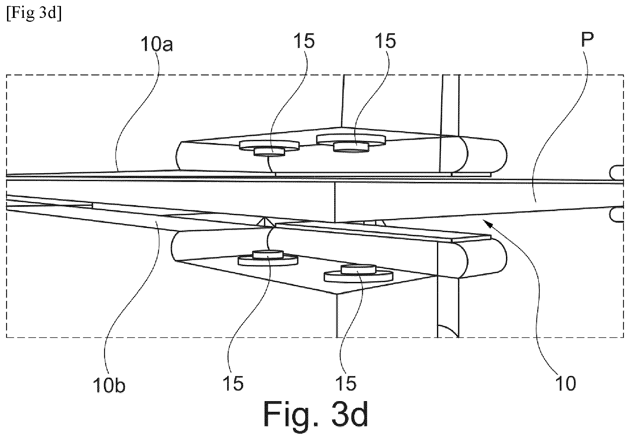

Pour une fente donnée, le dispositif comporte deux paires de premiers capteurs 15, une paire de premiers capteurs sur chacune des faces opposées 10a, 10b d'une fente 10, comme illustré sur les figures 3c et 3d.

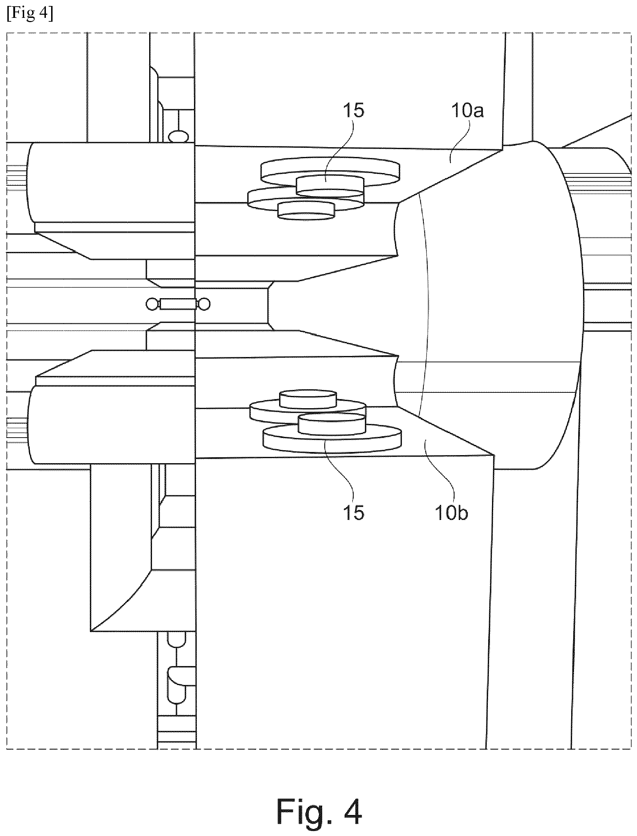

Pour une fente donnée, le dispositif comporter également deux paires de deuxièmes capteurs, une paire de deuxièmes capteurs sur chacune des faces opposées 10a, 10b d'une fente 10, comme visible sur la figure 4.

Pour une fente donnée, le dispositif comporte enfin une paire de capteurs de fond disposés côte à côte dans le fond de la fente 10.

Pour une fente donnée, le dispositif comporter ainsi dans cet exemple 10 capteurs pour une fente.

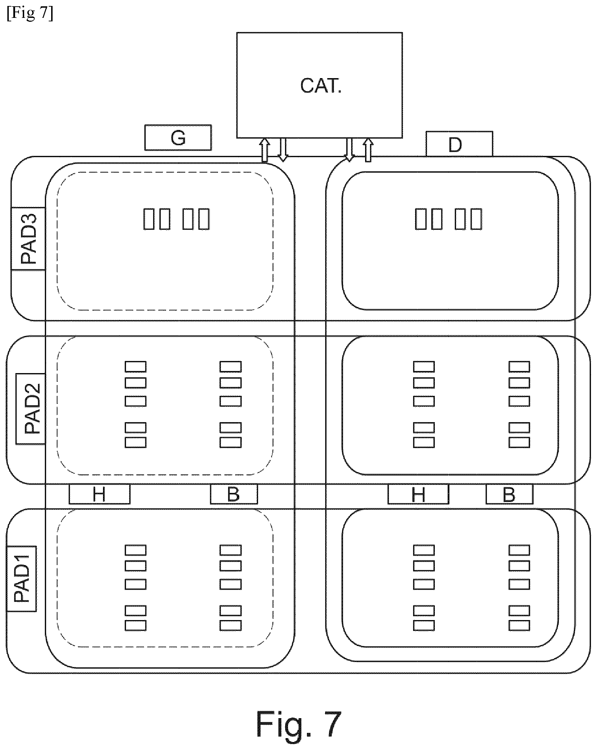

Le flux de gaz est asservi à la position de la plaquette dans la fente de la roue, et est régulé en pression et en débit. On va maintenant décrire la boucle d'asservissement des buses, en référence aux figures 6 et 7.

Après son positionnement dans la fente, les capteurs CPT de la fente permettent de déterminer la position de la plaquette. Plus précisément, on déterminer la distance entre la plaquette et chaque capteur de la fente, laquelle distance sert de donnée de référence REF.

Lorsque les roues commencent à tourner pour retourner la plaquette, les buses libèrent chacune un flux de gaz afin de maintenir la plaquette en position dans la fente, étant commandée chacune par une vanne EV. Les flux de gaz des buses sont contrôlés afin de conserver les distances enregistrées entre la plaquette et chaque capteur de la fente. On active les différentes vannes EV1 et EV2 des buses en fonction de la position de la plaquette donnée par les capteurs CPT1 et CPT2, au fur et à mesure du retournement, avec une valeur de consigne CSG1 et CSG2, comme détaillée à titre d'exemple sur la figure 6. Le flux de gaz peut être proportionnelle à la position de la plaquette dans la fente de la roue par rapport aux faces de la fente.

Le dispositif comporter un calculateur CAL permettant de contrôler les commandes des buses d'arrivée de gaz pour les buses des deux roues à la fois.

On a illustré à la figure 7, pour maintenir une plaquette donnée dans les deux fentes des roues droite D et gauche G, l'ensemble des capteurs CPTn, et vannes EVn, commandés par le calculateur CAL, en fonction de leur position dans la fente de la roue droite D ou de la roue gauche G, et dans les différents groupes de buses, vers la sortie de la fente PAD1, vers l'arbre PAD2 et sur l'arbre PAD3, sur la face supérieure des fentes H ou sur la face inferieure des fentes B.

Les différentes buses sont configurées pour fournir des flux de gaz dans différentes directions, afin de permettre la modification et l'ajustement de la position de la plaquette dans la fente. Lorsque les buses sont regroupées par trois, une buse centrale fournissant un flux de gaz central orienté perpendiculairement à la plaquette, et deux buses latérales fournissant deux flux de gaz respectivement orientés obliquement vers la gauche et vers la droite par rapport à la plaquette, en éloignement du flux central, comme illustré sur les figures 5b et 5c.

On va maintenant décrire le fonctionnement du dispositif 1, qui peut être intégré dans une ligne de fabrication de cellules photovoltaïques.

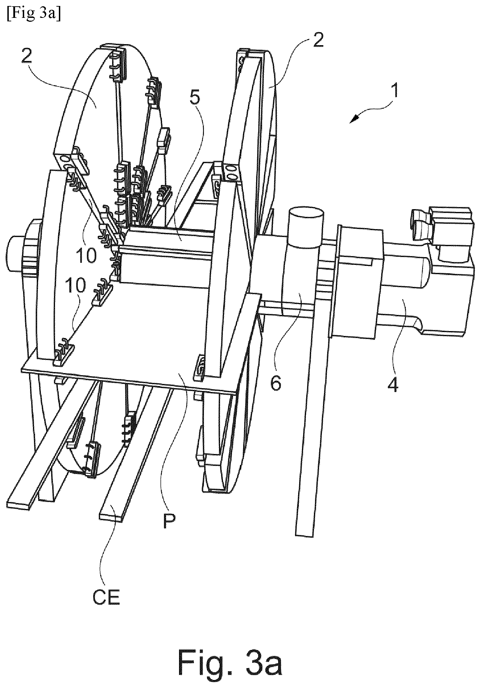

Dans une première position de réception de la plaquette, les deux fentes destinées à recevoir la plaquette sont placées à l'horizontal devant un convoyeur d'entrée CE, comme illustré à la figure 3a. On introduit la plaquette dans le dispositif de retournement, la plaquette étant entraînée horizontalement par le convoyeur d'entrée. Ainsi, la plaquette est placée dans les deux fentes des deux roues du dispositif qui se font face. La plaquette est alors maintenue entre les différents jets de gaz provenant des différentes buses des deux fentes correspondantes, comme décrit précédemment.

Ensuite, on entraine en rotation les deux roues du dispositif, en asservissant les flux de gaz sortant des buses à la position de la plaquette dans la fente correspondante de chacune des roues.

Enfin, on retire la plaquette du dispositif au moyen d'un convoyeur de sortie, une fois que les roues ont effectué une rotation de 180°. La plaquette a alors effectué un demi-tour sur elle-même. La plaquette peut être retirée en étant entraînée horizontalement par un convoyeur de sortie.

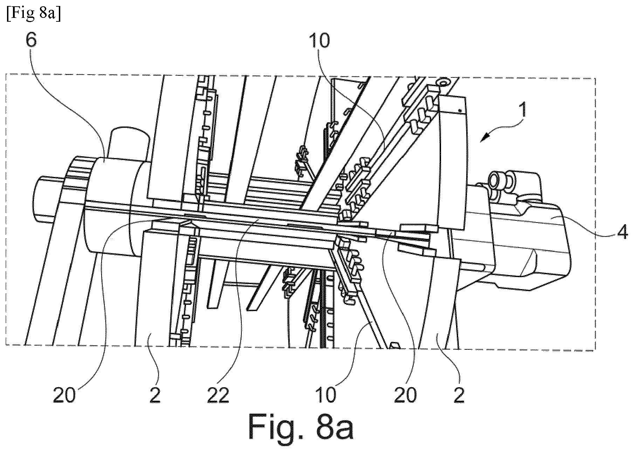

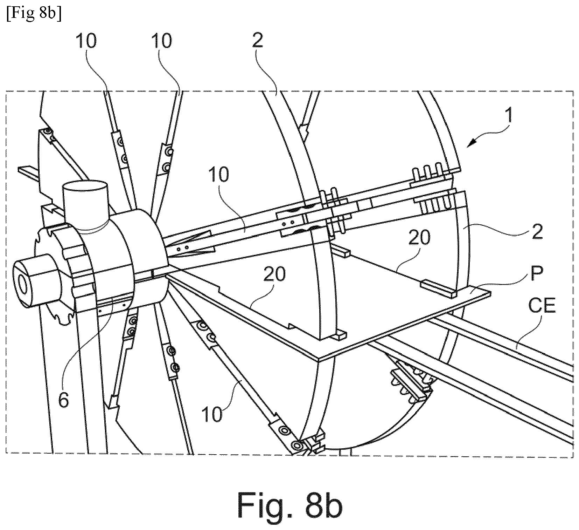

Dans une variante de réalisation illustrée aux figures 8a et 8b, le dispositif peut être configuré pour pouvoir être traversé par une plaquette sans retournement de celle-ci.

Chaque roue comporter à cet effet une fente 20 diamétralement traversante permettant le passage de la plaquette sans que celle-ci ne soit entraînée en rotation par les roues, qui est distincte des fentes 10 précédemment décrites.

En outre, l'arbre du dispositif comporte une fente 22 transversale horizontale permettant le passage de la plaquette sans que celle-ci ne soit entraînée en rotation par les roues.

La plaquette peut être entraînée à travers le dispositif par les convoyeurs d'entrée et de sortie sans entrer en contact avec le dispositif. Elle peut être supportée par ceux-ci, sans être maintenue dans le dispositif de retournement par des flux de gaz. La fente diamétralement traversante d'une roue est dans cet exemple dépourvue de capteurs et de buses. Afin de permettre le passage de la plaquette sans retournement, les roues sont placées de sorte que les fentes diamétralement traversantes des deux roues soient à l'horizontal, dans le prolongement de la fente transversale horizontale de l'arbre du dispositif, dans la position illustrée à la figure 8b.

La fente diamétralement traversante d'une roue est située angulairement entre deux fentes de réception d'une plaquette, à écart angulaire constant de chacune d'elles.

## Revendications

1. Dispositif (1) de retournement de plaquettes (P), comportant deux roues (2) parallèles l'une à l'autre, chaque roue (2) comportant au moins une fente (12) destinée à recevoir une plaquette (P) à retourner, les fentes (10) étant pourvues sur leurs faces (10A,10B), face à la plaquette, d'une pluralité de buses (12) d'arrivée de gaz, des flux de gaz sortant des buses (12) permettant de maintenir la plaquette dans une fente (10) correspondante de chacune des roues (2) sans contact avec les roues (2).

2. Dispositif selon l'une quelconque des revendications précédentes, comportant une pluralité de capteurs (15) de position configurés pour déterminer la position de la plaquette (P) par rapport aux roues (2).

3. Dispositif selon l'une quelconque des revendications précédentes, le flux de gaz étant asservi à la position de la plaquette (P) dans la fente (10) de la roue.

4. Dispositif selon l'une quelconque des revendications précédentes, le gaz (G) étant choisi dans la liste suivante : air, O₂, N₂, H₂.

5. Dispositif selon l'une quelconque des revendications précédentes, chaque roue (2) comportant un nombre égal de fente (10).

6. Dispositif selon l'une quelconque des revendications précédentes, une plaquette (P) étant reçue dans une fente (10) de chaque roue, les deux fentes (10) des deux roues étant sans décalage angulaire.

7. Dispositif selon l'une quelconque des revendications précédentes, les deux roues (2) étant symétriques l'une de l'autre par rapport à un plan central du dispositif.

8. Dispositif selon l'une quelconque des revendications précédentes, le dispositif comportant un calculateur (CAL) permettant de contrôler les commandes des buses (12) d'arrivée de gaz.

9. Dispositif selon l'une quelconque des revendications précédentes, comportant un moteur (4) d'entrainement des roues (2) en rotation.

10. Dispositif selon l'une quelconque des revendications précédentes, étant configuré pour que les roues (2) soient mobiles entre une première position de réception de la plaquette, dans laquelle la fente (10) destinée à recevoir la plaquette (P) est placée à l'horizontal devant un convoyeur d'entrée (CE), et une position de sortie de la plaquette, dans laquelle la fente recevant la plaquette est placée à l'horizontal devant un convoyeur de sortie.

11. Dispositif selon l'une quelconque des revendications précédentes, configuré pour pouvoir être traversé par une plaquette (P) sans retournement de celle-ci.

12. Ensemble comportant un dispositif (1) selon l'une quelconque des revendications précédentes, ainsi qu'un convoyeur d'entrée (CE) et un convoyeur de sortie.

13. Procédé de fabrication d'une cellule photovoltaïque, comportant les étapes suivantes :
(a) introduire une plaquette (P) dans un dispositif de retournement (1) selon l'une quelconque des revendications précédentes,
(b) entrainer en rotation les deux roues (2) du dispositif (1), en asservissant les flux de gaz sortant des buses (12) à la position de la plaquette (P) dans une fente (10) correspondante de chacune des roues (2).

14. Procédé selon la revendication précédente, comportant l'étape suivante :
(c) retirer la plaquette du dispositif, une fois que les roues ont effectué une rotation de 180°.

## Patentansprüche

1. Vorrichtung (1) zum Wenden von Wafern (P), umfassend zwei Räder (2), die parallel zueinander sind, wobei jedes Rad (2) mindestens einen Spalt (12) umfasst, der zum Aufnehmen eines zu wendenden Wafers (P) bestimmt ist, wobei die Spalte (10) an ihren Seiten (10A, 10B), gegenüber dem Wafer, mit einer Mehrzahl von Gaszuführungsdüsen (12) versehen sind, wobei aus den Düsen (12) austretende Gasströme es ermöglichen, den Wafer in einem entsprechenden Spalt (10) jedes der Räder (2) ohne Kontakt mit den Rädern (2) zu halten.

2. Vorrichtung nach einem der vorhergehenden Ansprüche, umfassend eine Mehrzahl von Positionssensoren (15), die dazu ausgestaltet sind, die Position des Wafers (P) in Bezug auf die Räder (2) zu ermitteln.

3. Vorrichtung nach einem der vorhergehenden Ansprüche, wobei der Gasstrom in Abhängigkeit von der Position des Wafers (P) in dem Spalt (10) des Rades geregelt wird.

4. Vorrichtung nach einem der vorhergehenden Ansprüche, wobei das Gas (G) aus der folgenden Liste gewählt ist: Luft, O₂, N₂, H₂.

5. Vorrichtung nach einem der vorhergehenden Ansprüche, wobei jedes Rad (2) eine gleiche Anzahl Spalte (10) umfasst.

6. Vorrichtung nach einem der vorhergehenden Ansprüche, wobei ein Wafer (P) in einem Spalt (10) jedes Rades aufgenommen wird, wobei die beiden Spalte (10) der beiden Räder keinen Winkelversatz aufweisen.

7. Vorrichtung nach einem der vorhergehenden Ansprüche, wobei die beiden Räder (2) in Bezug auf eine zentrale Ebene der Vorrichtung symmetrisch zueinander sind.

8. Vorrichtung nach einem der vorhergehenden Ansprüche, wobei die Vorrichtung einen Rechner (CAL) umfasst, der es ermöglicht, die Betätigungen der Gaszuführungsdüsen (12) zu steuern.

9. Vorrichtung nach einem der vorhergehenden Ansprüche, umfassend einen Motor (4) zum Drehantreiben der Räder (2).

10. Vorrichtung nach einem der vorhergehenden Ansprüche, wobei sie dazu ausgestaltet ist, dass die Räder (2) zwischen einer ersten Position zum Aufnehmen des Wafers, in welcher der zum Aufnehmen des Wafers (P) bestimmte Spalt (10) in der Horizontalen vor einem Zuförderer (CE) platziert ist, und einer Position zum Ausgeben des Wafers, in welcher der den Wafer aufnehmende Spalt in der Horizontalen vor einem Wegförderer platziert ist, beweglich sind.

11. Vorrichtung nach einem der vorhergehenden Ansprüche, die dazu ausgestaltet ist, von einem Wafer (P) ohne dessen Wenden durchquert werden zu können.

12. Anordnung, umfassend eine Vorrichtung (1) nach einem der vorhergehenden Ansprüche sowie einen Zuförderer (CE) und einen Wegförderer.

13. Verfahren zur Herstellung einer Photovoltaikzelle, umfassend die folgenden Schritte:
(a) Einführen eines Wafers (P) in eine Vorrichtung zum Wenden (1) nach einem der vorhergehenden Ansprüche,
(b) Drehantreiben der beiden Räder (2) der Vorrichtung (1), wobei die aus den Düsen (12) austretenden Gasströme in Abhängigkeit von der Position des Wafers (P) in einem entsprechenden Schlitz (10) jedes der Räder (2) geregelt werden.

14. Verfahren nach dem vorhergehenden Anspruch, umfassend den folgenden Schritt:
(c) Entnehmen des Wafers aus der Vorrichtung, sobald die Räder eine Drehung um 180° vollführt haben.

## Claims

1. Device (1) for inverting wafers (P), comprising two wheels (2) which are parallel to one another, each wheel (2) comprising at least one slot (12) intended to receive a wafer (P) to be inverted, the slots (10) being provided on their faces (10A, 10B), facing the wafer, with a plurality of gas inlet nozzles (12), gas flows exiting the nozzles (12) making it possible to hold the wafer in a corresponding slot (10) of each of the wheels (2) without contacting the wheels (2).

2. Device according to any one of the preceding claims, comprising a plurality of position sensors (15) which are configured to determine the position of the wafer (P) with respect to the wheels (2).

3. Device according to any one of the preceding claims, the gas flow being controlled on the basis of the position of the wafer (P) in the slot (10) of the wheel.

4. Device according to any one of the preceding claims, the gas (G) being selected from the following list: air, O₂, N₂, H₂.

5. Device according to any one of the preceding claims, each wheel (2) comprising an equal number of slots (10).

6. Device according to any one of the preceding claims, a wafer (P) being received in a slot (10) of each wheel, the two slots (10) of the two wheels having no angular offset.

7. Device according to any one of the preceding claims, the two wheels (2) being symmetrical to one another with respect to a central plane of the device.

8. Device according to any one of the preceding claims, the device comprising a computer (CAL) for controlling the commands of the gas inlet nozzles (12).

9. Device according to any one of the preceding claims, comprising a motor (4) for driving the wheels (2) in rotation.

10. Device according to any one of the preceding claims, being configured such that the wheels (2) are movable between a first position for receiving the wafer, in which the slot (10) intended to receive the wafer (P) is placed on the horizontal in front of an input conveyor (CE), and a position for outputting the wafer, in which the slot receiving the wafer is placed on the horizontal in front of an output conveyor.

11. Device according to any one of the preceding claims, configured to be able to be passed through by a wafer (P) without inversion of the latter.

12. Assembly comprising a device (1) according to any one of the preceding claims, and also an input conveyor (CE) and an output conveyor.

13. Method for manufacturing a photovoltaic cell, comprising the following steps:
(a) introducing a wafer (P) into an inverting device (1) according to any one of the preceding claims,
(b) driving the two wheels (2) of the device (1) in rotation, while the gas flows exiting the nozzles (12) are controlled on the basis of the position of the wafer (P) in a corresponding slot (10) of each of the wheels (2) .

14. Method according to the preceding claim, comprising the following step:
(c) removing the wafer from the device once the wheels have carried out a rotation of 180°.
